(19) Europäisches Patentamt / European Patent Office / Office européen des brevets

(11) **EP 4 773 336 A1**

(12) # EUROPEAN PATENT APPLICATION

(43) Date of publication:
08.07.2026 Bulletin 2026/28

(21) Application number: 25221340.0

(22) Date of filing: 08.12.2025

(51) International Patent Classification (IPC):
$H01M\ 10/48^{(2006.01)}$ $H01M\ 4/58^{(2010.01)}$
$G01R\ 31/378^{(2019.01)}$ $G01R\ 31/3842^{(2019.01)}$
$G01R\ 31/389^{(2019.01)}$

(52) Cooperative Patent Classification (CPC):
H01M 4/5825; G01R 31/378; G01R 31/3842;
G01R 31/389; H01M 10/48

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH LA MA MD TN

(30) Priority: 10.12.2024 KR 20240182809

(71) Applicant: SAMSUNG SDI CO., LTD.
Yongin-si, Gyeonggi-do 17084 (KR)

(72) Inventors:
• Kim, Hwasu
17084 Yongin-si, Gyeonggi-do (KR)
• Ahn, Gijang
17084 Yongin-si, Gyeonggi-do (KR)

(74) Representative: Meissner Bolte Partnerschaft
mbB
Patentanwälte Rechtsanwälte
Postfach 86 06 24
81633 München (DE)

(54) **DEVICE AND METHOD FOR DETECTING INTERNAL RESISTANCE OF BATTERY**

(57) The present disclosure relates to a device and a method for detecting an internal resistance of a battery (20). An internal resistance detection device (10) according to embodiments includes: a measuring device (12) configured to measure a state value of a battery (20); and a control device (13) configured to determine a state of charge (SOC) of the battery (20) based on the state value, estimate a lithium ion distribution state within a positive electrode active material of the battery (20) based on the SOC, determine a detection section depending on the lithium ion distribution state, and determine an internal resistance value of the battery (20) based on the state value measured within the detection section.

## FIG. 1

EP 4 773 336 A1

**Description**

**FIELD**

The present disclosure relates to a device and a method for detecting an internal resistance of a battery, and more particularly, the present disclosure relates to an apparatus and a method for detecting an internal resistance of a lithium-iron-phosphate battery.

**BACKGROUND**

A rechargeable battery is a battery that can be recharged and discharged, unlike a primary battery that cannot be recharged. A low-capacity rechargeable battery is used for small portable electronic devices such as a mobile phone, a notebook computer, and a camcorder and a large-capacity rechargeable battery is widely used as a power supply for driving a motor of a hybrid car, or the like, or a large-capacity power storage device. These rechargeable batteries include an electrode assembly having a positive electrode and a negative electrode, a case for accommodating the electrode assembly, and electrode terminals connected to the electrode assembly.

Typically, the rechargeable battery includes the electrode assembly including the positive electrode, the negative electrode, and the separator interposed between the positive electrode and the negative electrode, the case accommodating the electrode assembly, and the electrode terminal electrically connected to the electrode assembly. To enable charging and discharging of the battery through electrochemical reactions of the positive electrode, the negative electrode, and an electrolyte solution, an electrolyte is injected into the case. The shape of the case, such as a cylindrical or a rectangular, varies depending on the intended use of the battery.

The herein information disclosed in this Background section is only for enhancement of understanding of the background of the disclosure and therefore it may contain information that does not form the prior art that is already known in this country to a person of ordinary skill in the art.

**SUMMARY**

The present disclosure provides a device and a method for a detection of an internal resistance capable of improving the accuracy of the internal resistance measurement of the LFP battery.

The objects of the present disclosure are not limited to the herein-mentioned objects, and other non-mentioned objects can be clearly understood to those skilled in the art from the following description.

The present disclosure relates to an internal resistance detection device of a battery, including: a measuring device configured to measure a state value of a battery; and a control device configured to determine a state of charge (SOC) of the battery based on the state value, estimate a lithium ion distribution state within a positive electrode active material of the battery based on the SOC, determine a detection section depending on the lithium ion distribution state, and determine an internal resistance value of the battery based on the state value measured within the detection section.

The positive electrode active material may include LFP(LiFePO$_4$). The lithium ion (Li) distribution state may include a distribution state of an Li-rich phase region including an Li$_x$FePO$_4$ (x $\geq$ 0.9) phase and an Li-poor phase region including an Li$_y$FePO$_4$ (y $\leq$ 0.05) phase within a positive electrode active material particle.

The control device may be the further configured to calculate an internal resistance variation index based on the lithium ion distribution state. The control device may be the further configured to determine a section in which the internal resistance variation index satisfies a predetermined condition as the detection section.

The control device may be the further configured to convert a region between an outer boundary and the center of the positive electrode active material particle into a one-dimensional coordinate system, and estimate a starting position within the positive electrode active material particle of the Li-rich phase region and the Li-poor phase region by using the one-dimensional coordinate system. The control device may be the further configured to calculate the internal resistance variation index based on the starting position. The starting position of the Li-rich phase region may correspond to the relative distance between the outer boundary and the Li-rich phase region. The starting position of the Li-poor phase region may correspond to the relative distance between the outer boundary and the Li-poor phase region.

The internal resistance variation index during charging may decrease as the thickness of the Li-rich phase region located closest to the outer side of the positive electrode active material particles increases if charging is initiated in a state where the Li-rich phase region exists on the outer boundary of the positive electrode active material particle. The internal resistance variation index during discharging may decrease as the thickness of the Li-poor phase region located closest to the outer side of the positive electrode active material particle increases if the discharge is initiated in a state where the Li-poor phase region exists on the outer boundary of the positive electrode active material particle.

The control device may be the further configured to determine that the predetermined condition is satisfied if the internal resistance variation index is less than a threshold value.

An open circuit voltage of the battery may be maintained flat within a predetermined SOC range. The control device may be the further configured to determine the detection section in a section where the SOC of the battery is included within the SOC range.

The control device may be the further configured to determine the detection section in a charging section after a charging is maintained for more than a first time, or in a discharging section after a discharging is maintained for more than the first time. The first time may be set based on a time constant of a parallel impedance constituting the equivalent circuit model of the battery.

The control device may be the further configured to determine the detection section in a corresponding charging section or discharging section if the charging or discharging is initiated while an idle time is less than a second time.

The control device may be the further configured to: detect, via the measuring device, a first voltage value and a first current value of the battery at a first point in a time within the detection section; and detect, via the measuring device, a second voltage value and a second current value of the battery at a second point in a time within the detection section. The control device may be the further configured to calculate the internal resistance value by using a voltage difference between the first voltage value and the second voltage value and a current difference between the first current value and the second current value.

The present disclosure also relates to an internal resistance detection method of a battery including: measuring a status value of a battery, determining an SOC of the battery based on the status value; estimating a lithium ion distribution state in a positive electrode active material of the battery based on the SOC of the battery; determining a detection section depending on the lithium ion distribution state; and determining an internal resistance value of the battery based on the state value measured within the detection section.

The positive electrode active material may include LFP ($LiFePO_4$). The lithium ion distribution state may include a distribution state of an Li-rich phase region including an $Li_xFePO_4$ ($x \geq 0.9$) phase and an Li-poor phase region including an $Li_yFePO_4$ ($y \leq 0.05$) phase within a positive electrode active material particle.

The determining the detection section may include: calculating an internal resistance variation index based on the lithium ion distribution state; and determining a section in which the internal resistance variation index satisfies a predetermined condition as the detection section.

The estimating the lithium ion distribution state may include: converting a region between an outer boundary and the center of the positive electrode active material particle into a one-dimensional coordinate system; and estimating a starting position within the positive electrode active material particle of the Li-rich phase region and the Li-poor phase region by using the one-dimensional coordinate system.

The calculating the internal resistance variation index may include calculating the internal resistance variation index based on the starting position. The starting position of the Li-rich phase region may correspond to the relative distance between the outer boundary and the Li-rich phase region. The starting position of the Li-poor phase region may correspond to the relative distance between the outer boundary and the Li-poor phase region.

The internal resistance variation index during charging may decrease as the thickness of the Li-rich phase region located closest to the outer side of the positive electrode active material particles increases if charging is initiated in a state where the Li-rich phase region exists on the outer boundary of the positive electrode active material particle. The internal resistance variation index during discharging may decrease as the thickness of the Li-poor phase region located closest to the outer side of the positive electrode active material particle increases if the discharge is initiated in a state where the Li-poor phase region exists on the outer boundary of the positive electrode active material particle.

The determining the section in which the internal resistance variation index satisfies the condition as the detection section may include determining that the condition is satisfied if the internal resistance variation index is less than a threshold value.

An open circuit voltage of the battery is maintained flat within a predetermined SOC range. The determining the detection section may include determining the detection section in a section where the SOC is included within the SOC range.

The determining the detection section may include determining the detection section in a charging section after the charging is maintained for more than a first time, or in a discharging section after the discharging is maintained for more than the first time.

The first time may be set based on a time constant of a parallel impedance constituting an equivalent circuit model of the battery.

The determining the detection section may include determining the detection section in the corresponding charging section or discharging section if the charging or discharging is initiated in a state that an idle time is less than a second time.

The determining the internal resistance value may include: obtaining a first voltage value and a first current value of the battery measured at a first point in time within the detection section; obtaining a second voltage value and a second current value of the battery measured at a second point in time within the detection section; and calculating the internal resistance value by using a voltage difference between the first voltage value and the second voltage value and a current difference between the first current value and the second current value.

According to the present disclosure, the accuracy of measuring the internal resistance of the LFP battery may be improved.

The effects that may obtain through the present disclosure are not limited to the foregoing effects, and other non-mentioned effects will be clearly understood by those skilled in the art from the description herein

## BRIEF DESCRIPTION OF THE DRAWINGS

The following drawings attached to this specification illustrate preferred embodiments of the present disclosure and, together with the detailed description of the disclosure described herein, serve to further understand the technical idea of the present disclosure; therefore, the present disclosure should not be interpreted as being limited to matters described in such drawings.

FIG. 1 is a view schematically illustrating an internal resistance detection device according to embodiments.
FIG. 2 is a view illustrating an example of a battery equivalent circuit model.
FIG. 3 is a view showing an example of a voltage profile of a battery.
FIG. 4A and FIG. 4B are views for explaining a method for detecting an internal resistance value by an internal resistance detection device according to embodiments.
FIG. 5A to FIG. 5D are views illustrating examples of modeling a distribution state of lithium ions within a positive electrode active material particle of a battery.
FIG. 6A to FIG. 6D are views for explaining how a distribution state of lithium ions within a positive electrode active material particle of a battery changes depending on a charge and discharge path.
FIG. 7A to FIG. 7D are views for explaining a method for recording a distribution state of lithium ions in a positive electrode active material of a battery by an internal resistance detection device according to embodiments.
FIG. 8A and FIG. 8B are views for explaining a change in an internal resistance according to a charge and discharge path of a battery.
FIG. 9 is a view illustrating an example of an internal resistance detection device determining an internal resistance detection section according to embodiments.
FIG. 10 is a view schematically illustrating a method for detecting an internal resistance of a battery according to embodiments.

## DETAILED DESCRIPTION

Hereinafter, embodiments of the present disclosure will be described in detail with reference to the accompanying drawings. Prior to description, it should be understood that terms and words used in the specification and the appended claims should not be construed as having common and dictionary meanings, but should be interpreted as having meanings and concepts corresponding to technical ideas of the present disclosure in view of the principle that the inventor can properly define the concepts of the terms and words in order to describe his/her own disclosure as best as possible. Accordingly, since the embodiment described in the specification and the configurations shown in the drawings are merely the most preferable embodiment and configurations of the present disclosure, they do not represent all of the technical ideas of the present disclosure, and it should be understood that that various equivalents and modified examples, which may replace the embodiments, are possible when filing the present application. It will be further understood that the terms "comprise, include," "comprising," and/or "including," when used in this specification, specify the presence of the stated features, integers, steps, operations, elements, and/or components but do not preclude the presence or addition of one or more other features, integers, steps, operations, elements, components, and/or groups thereof. The use of "can/may" in describing embodiments of the present disclosure may include "one or more embodiments of the present disclosure."

In addition, in order to help understanding of the present disclosure, the accompanying drawings are not drawn to scale, and the dimensions of some components may be exaggerated. In addition, the same reference numerals may be assigned to the same elements in different embodiments.

When it is explained that two objects are 'identical', this means that these objects are 'substantially identical'. Accordingly, the substantially identical objects may include deviations considered low in the art, for example, deviations within 5 %. In addition, when it is explained that certain parameters are uniform in a predetermined region, this may mean that the parameters are uniform in terms of an average in the corresponding region.

Although the terms "first", "second", and the like are used to describe various constituent elements, these constituent elements are not limited by these terms. These terms are used to distinguish one element from another, and unless stated to the contrary, a first element may be a second element.

Throughout the specification, unless stated otherwise, each element may be singular or plural.

When an element is "above (or under)" or "on (or below)" another element, the element can be on an upper surface (or a lower surface) of the other element, and intervening elements may be present between the element and the other element on (or below) the element.

In addition, when an element is referred to as being "connected", "coupled" or "linked" to another element, the element can be directly connected or coupled to the other element, but it should be understood that intervening elements may be present between each element, or each element may be "connected", "coupled" or "linked" to each other through another element. When one element is referred to as being coupled (e.g., electrically coupled or connected) to another element, the one element may be directly coupled to that another element or indirectly coupled to that another element via one or more intervening elements.

Throughout the specification, unless stated otherwise, "A and/or B" refers to A, B, or A and B. In other words, the term "and/or" includes all or various combinations of a plurality of items that are related and arranged. "C to D" refers to C or greater and D or smaller, unless stated otherwise.

A lithium-iron-phosphate (LFP: $LiFePO_4$) battery is a lithium ion battery and is the rechargeable using a LFP as a positive electrode active material. The LFP positive electrode active material have a two-phase transition characteristic in which two phases coexist and a transition occurs. The two-phase transition characteristic generates an additional over-potential in the LFP batteries. This over-potential varies depending on a previous charge/discharge history and a idle time of the LFP battery, which makes it difficult to measure the internal resistance of the LFP battery.

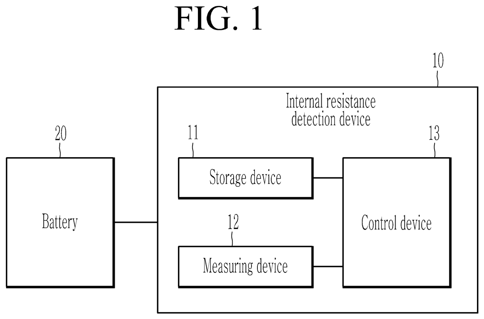

FIG. 1 schematically illustrates an internal resistance detection device according to embodiments.

Referring to FIG. 1, an internal resistance detection device 10 according to embodiments may include a storage device 11, a measuring device 12, and a control device 13.

The storage device 11 may store information, data, etc. processed in the internal resistance detection device 10. The storage device 11 may also store a program for the operation of the control device 13 described later.

The storage device 11 may include at least one memory (not shown). The memory is a computer-readable storage medium, and may include various forms of volatile or nonvolatile storage media. The memory may include various forms of recording medium, such as flash memory type, hard disk type, card type (e.g., SD or XD memory), random access memory (RAM), static random access memory (SRAM), read-only memory (ROM), electrically erasable programmable read-only memory (EEPROM), and programmable read-only memory (PROM).

The measuring device 12 may periodically measure the status value of the battery 20. The measuring device 12 may measure the status values such as a voltage, a current, and a temperature of the battery 20. The measuring device 12 may include at least one sensor or measuring circuit for measuring the state value of the battery 20.

The control device 13 may control the overall operation of the internal resistance detection device 10.

The control device 13 may obtain the status values of the battery 20 via the measuring device 12. The control device 13 may use the state values to determine a state of charge (SOC), a state of health (SOH), an open circuit voltage (OCV), an internal resistance value, etc. of the battery 20.

The battery 20 may be a lithium iron phosphate ($LiFePO_4$, hereinafter, referred to as 'LFP') battery (or LFP battery cell). The LFP battery has various unique characteristics in comparison with other lithium ion batteries using cobalt, nickel, manganese, or the like as a positive electrode active material. In the LFP battery, lithium ions ($Li^+$) are deintercalated or intercalated during the process of charging or discharging the battery, so that a lithium-rich $Li_xFePO_4$ ($x \geq 0.9$) phase and a lithium-poor $Li_yFePO_4$ ($y \leq 0.05$) phase coexist in the positive electrode, thereby having a two-phase transition characteristic in which transition occurs between the two phases. These two-phase transition characteristics may be expressed by the following reaction formula.

[Reaction formula] $\qquad Li_xFePO_4 \leftrightarrow Li_yFePO_4 + (x - y)Li^+ + (x - y)e^-$

In the above reaction formula, $Li^+$ and $e^-$ represent lithium ions and electrons, respectively, and x and y represent composition ranges. The composition range refers to a range over which the relative ratios of corresponding constituent elements in a particular compound can vary. Hereinafter, for better understanding and ease of description, the $Li_xFePO_4$ phase is referred to as a 'Li-rich phase', and the $Li_yFePO_4$ phase is referred to as a 'Li-poor phase'. The Li-rich phase may include a state in which lithium ions are maximally intercalated so that x becomes 1 (i.e., $LiFePO_4$). In addition, the Li-poor phase may include a state in which lithium ions are completely removed so that y becomes 0 (i.e., $FePO_4$).

The internal resistance and the additional overpotential generated due to this of the LFP battery 20 may vary depending on a charge/discharge history (a charge maintenance time/discharge maintenance time, an idle time), lithium ion (Li) distribution status, SOC, etc.

The control device 13 may detect the internal resistance value of the battery 20 in the section where the charge/discharge history, the lithium ion distribution status, and the SOC of the battery 20 satisfy predetermined conditions, in order to prevent the internal resistance detection accuracy from being lowered due to the variation in the internal resistance and the overpotential.

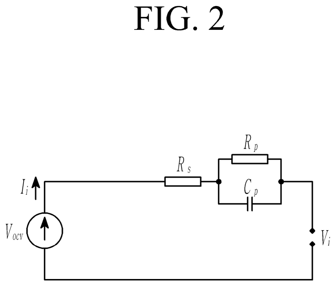

Hereinafter, a method for the control device 13 to detect the internal resistance of the battery 20 will be described in detail. with reference to FIG. 2 to FIG. 9,

First, the control device 13 may determine the internal resistance detection section (or the internal resistance detection window) based on the charge/discharge history (the charge maintenance time/discharge maintenance time, the idle time) of the battery 20, the lithium ion distribution status, and the SOC.

FIG. 2 is a view illustrating an example of an equivalent circuit model (ECM) of a battery.

Referring to FIG. 2, the ECM is a battery model that simplifies the battery 20 into an electric circuit. Parameters that constitute the ECM may include an open circuit voltage Vocv, a series resistance Rs, and a parallel impedance (a parallel resistance, Rp), and a parallel capacitance Cp. The series resistance Rs represents an Ohm resistance inside the battery 20 and is related to a voltage drop phenomenon when discharging the battery 20 and a voltage rise phenomenon when charging the battery 20. The parallel resistance Rp and the parallel capacitance Cp represent a charge transmission resistance and a charge transmission capacitance, respectively, and are related to the dynamic characteristics of the battery 20.

The internal resistance of the battery 20 may be determined by the sum of the series resistance Rs and the parallel resistance Rp. Therefore, the lower the current flowing through the parallel capacitance Cp, the higher the detection accuracy of the internal resistance value. If the charging or discharging of the battery 20 continues for a predetermined time without changing the current direction, a state occurs in which almost no current flows through the parallel capacitance Cp.

Accordingly, the control device 13 can determine the section that satisfies the condition (the first condition) that the charge maintenance time or the discharge maintenance time of the battery 20 is longer than a predetermined time (hereinafter referred to as a minimum maintenance time) as an internal resistance detection section. The charge maintenance time may mean the time that the charging continues without the interruption of the charge current (i.e., without an event that interrupts the flow of the charge current or changes the direction of the current). The discharge maintenance time may mean the time that the discharge continues without the interruption of the discharge current (i.e., without an event that interrupts the flow of the discharge current or changes the direction of the current). The control device 13 may count the charge maintenance time and discharge maintenance time using a counter. The control device 13 may count the charge maintenance time and the discharge maintenance time by continuously increasing the counter value when charging or discharging is initiated and resetting the counter value to 0 when the current becomes 0 (idle period) or the direction of the current changes (from charging to discharging or from discharging to charging).

The control device 13 may determine the internal resistance detection section in the section after the charge of the battery 20 is maintained for the minimum maintenance time or longer when the battery 20 is charging. The control device 13 may determine the internal resistance detection section in the section after the discharge is maintained for the minimum maintenance time or longer when the battery 20 is discharging.

The minimum maintenance time may be determined by the parallel impedance among the internal impedances of the LF battery 20. When the charging or discharging of the battery 20 continues for $5\tau$ or more, a state occurs in which almost no current flows through the parallel capacitance Cp. Therefore, the minimum maintenance time is $5\tau$ Cp. The time constant $\tau$ of the parallel impedance and the minimum maintenance time determined based on the time constant $\tau$ may be determined in advance using experiments, simulations, etc. during the design process of the battery 20 and then stored in the storage device 11.

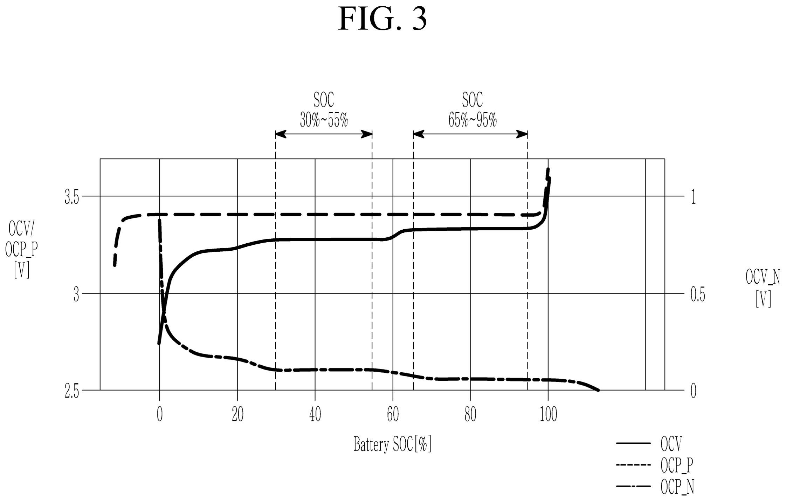

FIG. 3 is a view showing an example of a voltage profile of a battery. The voltage profile is a voltage curve generated by corresponding changes in an open circuit voltage OCV, a positive electrode open circuit potential OCP_P, and a negative electrode open circuit potential OCP_N of the battery 20 with respect to changes in the SOC of the battery 20.

Due to a two-phase transition characteristic of the LFP battery 20, a phase separation phenomenon occurs in which a Li-rich phase and a Li-poor phase coexist within the cathode of the LFP battery 20. When the phase separation occurs, the Li-rich phase and the Li-poor phase coexist and are spatially separated to form a Li-rich phase region and a Li-poor phase region. In addition, due to the coexistence of the Li-rich phase and the Li-poor phase, the open circuit potential (OCP) of the positive electrode of the battery 20 has a potential plateau section that maintains a constant potential regardless of the change in the SOC of the battery 20. This is because in a phase-separated state, the Li-rich phase and the Li-poor phase maintain phase equilibrium, so the change in Gibbs free energy remains constant.

Referring to FIG. 3, the positive electrode open circuit potential OCP_P and the negative electrode open circuit potential OCP_N of the battery 20 have a section in which the potential value is maintained constant regardless of the SOC of each electrode. Accordingly, the open circuit voltage OCV of the battery 20 also has a section (hereinafter referred to as an OCV flat section) in which the voltage value remains constant regardless of the SOC of the battery 20. Referring to 3 as an example, the flat section of the open circuit voltage OCV may appear in the section where the SOC of the battery 20 is between SOC 30% and SOC 55% and in the section where the SOC is between SOC 65% and SOC 95%. The flat section of the positive electrode open circuit potential OCP_P, the negative electrode open circuit potential OCP_N, and the open circuit voltage (OCV) may vary depending on the chemical composition of the battery 20 (e.g., the composition of the negative electrode) and the manufacturing process. The OCV flat section of the battery 20 may be determined in advance using experiments, simulations, etc. during the design process of the battery 20 and then stored in the storage device 11.

The OCV flat section of FIG. 3 represents a OCV flat section when the temperature of the battery 20 is included in a room temperature section at a beginning of life (BOL), and the OCV flat section of the battery 20 may change depending on the temperature of the battery 20, a SOH, etc. Accordingly, the OCV flat section of the battery 20 may be determined for each temperature condition or SOH by various methods such as the experiments and the simulations, and the OCV flat section determined in this way may be mapped to the corresponding temperature condition or SOH and stored in the storage device 11.

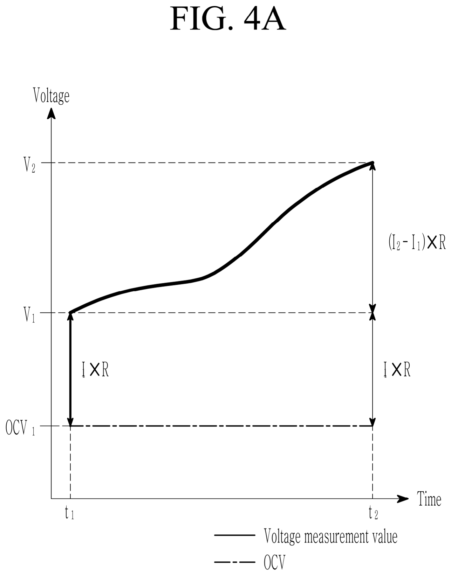

FIG. 4A and FIG. 4B are views for explaining a method for detecting an internal resistance value in an OCV flat section. FIG. 4A is the view illustrating a case where the OCV is flat, and FIG. 4B is the view illustrating a case where the OCV changes.

Referring to FIG. 4A, both the voltage measurement value $V_2$ and the current measurement value $I_2$ at a time $t_2$ increased compared to the voltage measurement value $V_1$ and the current measurement value $I_1$ at a time $t_1$. However, an OCV variation ($OCV_1$-$OCV_1$) of the battery 20 between the time $t_1$ and the time $t_2$ converges to 0. Therefore, since the OCV variation is not reflected in the voltage variation ($V_2$-$V_1$) of the battery 20, the internal resistance value R of the battery 20 may be calculated using mathematical formula1.

$$[Mathematical\ Formula\ 1]$$

$$R = (V_2 - V_1) / (I_2 - I_1)$$

$$R = (V2 - V1) / (I2 - I1)$$

Referring to Fig. 4B, both the voltage measurement value $V_2$ and the current measurement value $I_2$ at the time $t_2$ increased compared to the voltage measurement value $V_1$ and the current measurement value $I_1$ at the time $t_1$. The OCV ($OCV_2$) of the battery 20 at the time $t_2$ also increased compared to the OCV ($OCV_1$) of the battery 20 at the time $t_1$. Therefore, it is difficult to calculate the internal resistance of the battery 20 using Mathematical formula1 above because the OCV variation ($OCV_2$-$OCV_1$) is reflected in the voltage variation ($V_2$-$V_1$) of the battery 20.

Accordingly, the control device 13 can determine the internal resistance detection section in a section that satisfies the condition (a second condition) that the SOC of the battery 20 is included within a SOC range corresponding to the OCV flat section. The control device 13 determines the section corresponding to the OCV flat section as the internal resistance detection section, thereby enabling the determination of the internal resistance of the battery 20 through a simple calculation as in Mathematical formula1 above.

The battery 20 using LFP as a positive electrode active material has a path dependency in which the internal resistance changes depending on the charge/discharge path. The charge/discharge path represents the history of changes in the SOC (or the depth of the discharge (DOD)) of the battery 20 during the charging/discharging of the battery 20. When comparing the case where the battery 20 is continuously discharged from SOC 100% to SOC 50% and the case where the battery 20 is continuously charged from SOC 0% to SOC 50%, the discharge and charge of the battery 20 are terminated at the same SOC 50%, but the charge and discharge paths until the SOC reaches 50% are different. In this way, if the charge and discharge paths are different from each other, even if the SOC of the battery 20 is the same, the distribution state of lithium ions within the positive electrode may be different from each other.

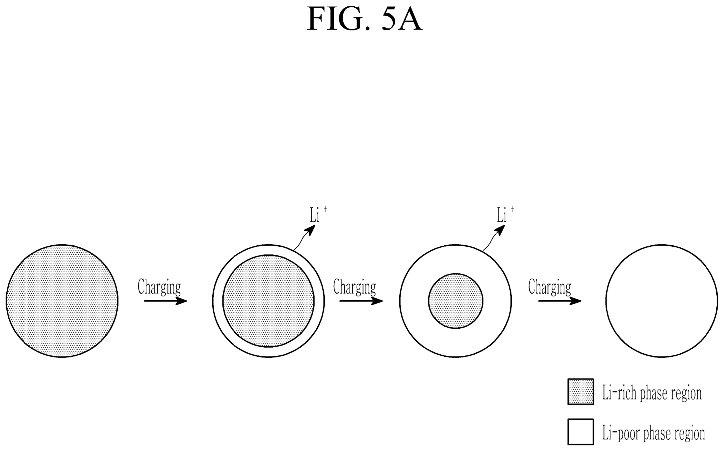

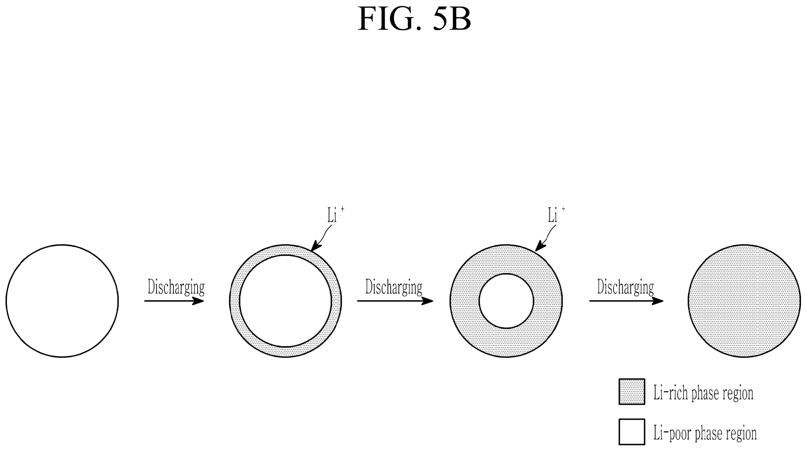

FIG. 5A and FIG. 5B are views illustrating an example of modeling a distribution state of lithium ions within positive electrode active material particle of a battery 20. FIG. 5A and FIG. 5B are examples of modeling the distribution state of lithium ions within the positive electrode active material particle using a radial modeling. FIG. 5A illustrates an example of how the distribution state of lithium ions changes within positive electrode active material particle during the charging, and FIG. 5b illustrates an example of how the distribution state of lithium ions changes within the positive electrode active material particle during the discharging.

Referring to Fig. 5A, in the fully discharged state of the battery 20, only the Li-rich phase may exist inside the positive electrode active material particle. Afterwards, when the battery 20 is charged, lithium ions (Li) are deintercalated from the outer boundary (surface) of the positive electrode active material particle and move to the negative electrode. Accordingly, as the charging progresses, the Li-poor phase region is created on the outer (surface) side of the positive electrode active material particle, and the phase separation occurs in which the Li-poor phase and the Li-rich phase exist at the surface and center of the positive electrode active material particle, respectively. As charging progresses, the interface (or the boundary) between the Li-poor phase region and the Li-rich phase region gradually moves toward the center side of the positive electrode active material particle. Next, when the battery 20 is fully charged, all lithium ions (Li) escape to the negative electrode side, so that only the Li-poor phase may exist inside the positive electrode active material particle.

Referring to FIG. 5B, in the fully charged state of the battery 20, only the Li-poor phase may exist inside the positive electrode active material particle. Afterwards, when the battery 20 is discharged, lithium ions (Li) are intercalated from the outer boundary (surface) of the positive electrode active material particle. Accordingly, as discharge proceeds, a Li-rich phase region is created on the outer side of the positive electrode active material particle, and phase separation occurs in which a Li-rich phase and a Li-poor phase exist at the surface and the center of the positive electrode active material particle, respectively. As the discharge progresses, the interface (or the boundary) between the Li-poor phase region and the Li-rich phase region gradually moves toward the center side of the positive electrode active material particle. Next, when the battery 20 is in the completely discharged state, lithium ions (Li) are completely filled inside the positive electrode active material particle, so that only the Li-rich phase can exist inside the positive electrode active material particle.

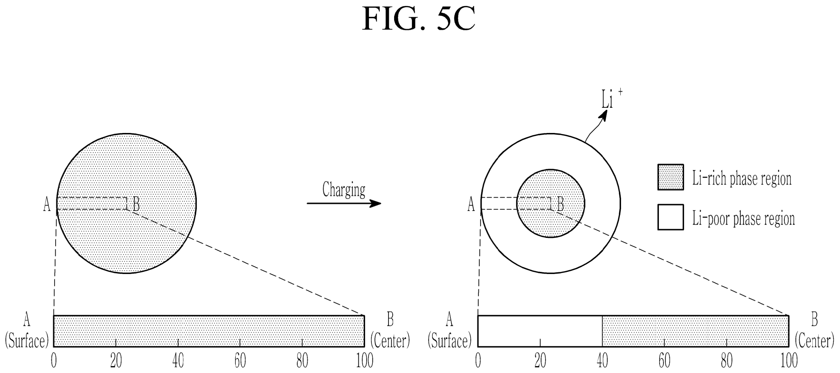

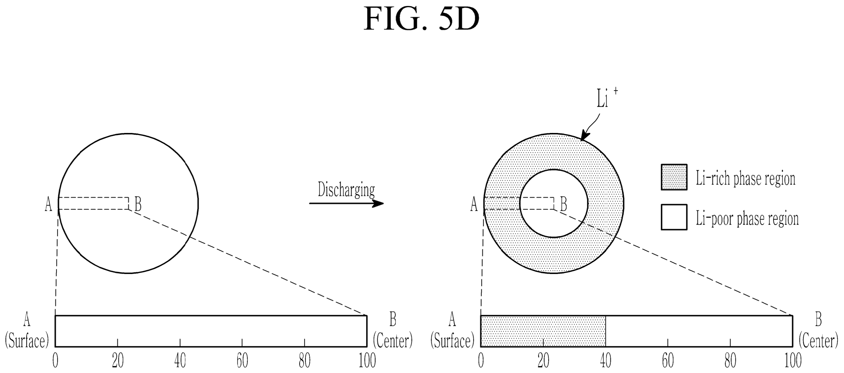

FIG. 5C to FIG. 5D are views illustrating other examples modeling a distribution state of lithium ions within a positive electrode active material particle of a battery 20. FIG. 5C and FIG. 5D are examples of modeling the distribution state of lithium ions within positive electrode active material particle using a bar graph. FIG. 5C illustrates an example of how the distribution state of lithium ions changes within the positive electrode active material particle during the charging, and FIG. 5D illustrates an example of how the distribution state of lithium ions changes within the positive electrode active material particle during the discharging.

The bar graphs in FIG. 5C and FIG. 5D illustrate the distribution of lithium ions Li between the center and the outer boundary of the positive electrode active material particle by converting them into a one-dimensional coordinate system. In the bar graph, the left end represents the outer boundary (i.e., the surface) of the positive electrode active material particle, and the right end represents the center of the positive electrode active material particle. In the bar graph, coordinate values (0 to 100) represent the relative distance from the outer boundary of the positive electrode active material particle. Referring to FIG. 5C and FIG. 5D as examples, the coordinate values decrease toward the left in the bar graph (i.e., closer to the outer boundary of the positive electrode active material particle), and the coordinate values increase toward the right (i.e., closer to the center of the positive electrode active material particle). Using these bar graphs, the changes in the distribution state of lithium ions within the positive electrode active material particle may be recorded by converting them into coordinate values.

Meanwhile, FIG. 5A to FIG. 5D illustrate a case where the battery 20 is continuously charged from the fully discharged state to the fully charged state, or continuously discharged from the fully charged state to the fully discharged state. However, during the actual use of the battery 20, there may frequently be cases where only a portion of the capacity of the battery 20 is repeatedly charged and discharged.

Therefore, depending on the charge/discharge path of the battery 20, multiple interfaces of the Li-poor phase regions and the Li-rich phase regions may exist inside the positive electrode active material particle.

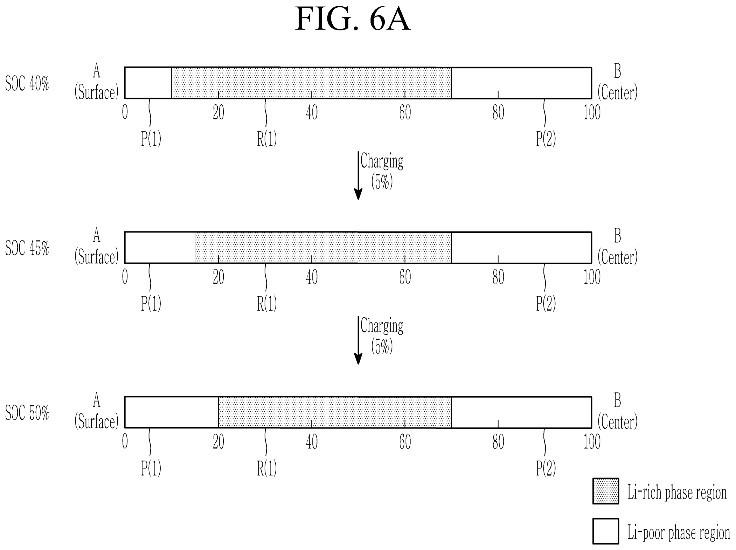

FIG. 6A to FIG. 6D are drawings for explaining how the distribution state of lithium ions within the positive electrode active material particle changes depending on the charge and discharge path. In FIG. 6A to FIG. 6D, R(i) and P(i) represent the Li-rich phase region and the Li-poor phase region, respectively, located at the i-th position from the outer boundary (the surface) of the positive electrode active material particle.

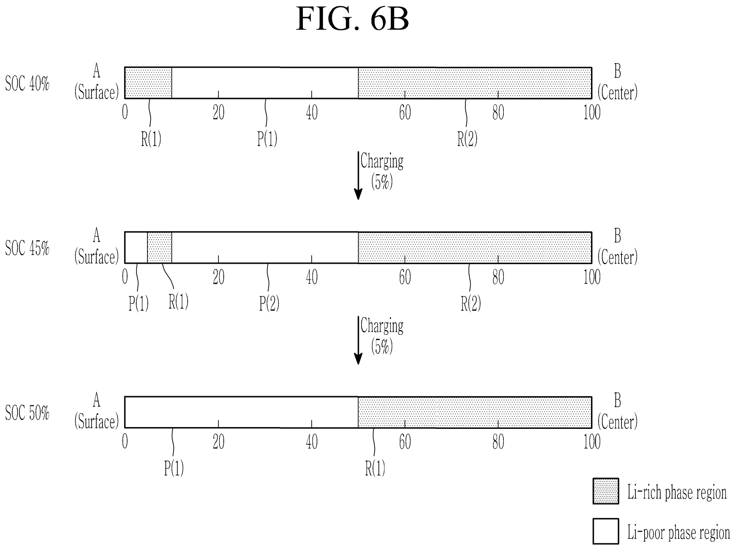

In FIG. 6A and FIG. 6B, the battery 20 is charged from SOC 40% to SOC 50%. However, due to the difference in the charge/discharge path before reaching 40% SOC, the distributions of the Li-rich phase region and the Li-poor phase region appear differently in FIG. 6A and FIG. 6B.

Referring to FIG. 6A, at the SOC of 40% of the battery 20, the Li-poor phase regions P(1) and P(2) exist at the outer boundary (or the surface) and center of the positive electrode active material particle, respectively, and the Li-rich phase region R(1) exists between two Li-poor phase regions P(1) and P(2). Thereafter, when the charging of the battery 20 begins, lithium ions are released from the Li-rich phase region R(1), and as a result, the interface between the Li-poor phase region P(1) and the Li-rich phase region R(1) may gradually move toward the center of the positive electrode active material particle.

Referring to FIG. 6B, at the SOC 40% of the battery 20, the Li-rich phase regions R(1) and R(2) exist at the outer boundary (surface) and center of the positive electrode active material particle, respectively, and the Li-poor phase region P(1) exists between two Li-rich phase regions R(1) and R(2). Thereafter, when the charging of the battery 20 begins, lithium ions may escape from the outer boundary of the Li-rich phase region R(1) to create the Li-poor phase region P(1) on the outer boundary of the positive electrode active material particle. When the SOC of the battery 20 reaches 50%, all previous Li-rich phase regions R(1) may be transited to Li-poor phase regions P(1), and only one Li-poor phase region P(1) and one Li-rich phase region R(1) may exist at the outer boundary and center of the positive electrode active material particle, respectively.

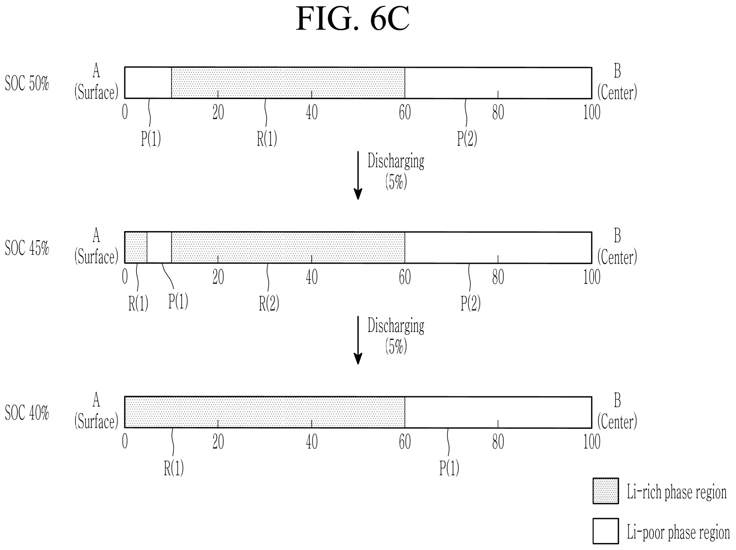

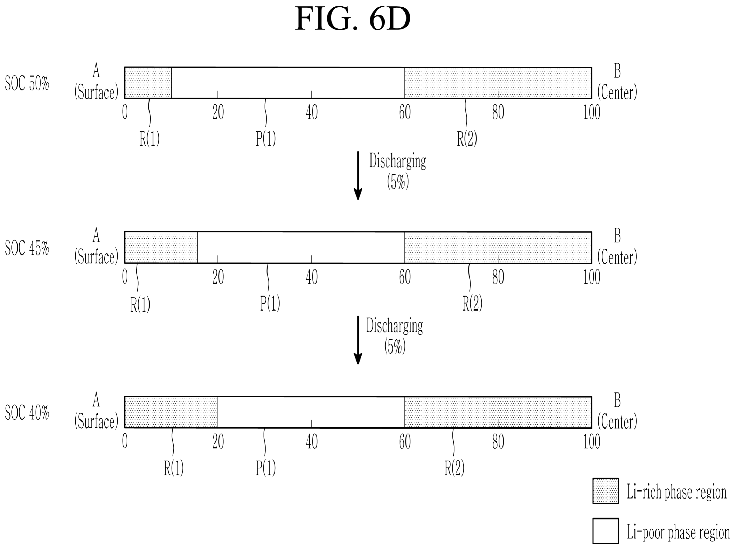

In FIG. 6C and FIG. 6D, the battery 20 is discharged from the SOC 50% to the SOC 40%. However, due to the difference in the charge/discharge path before reaching the SOC 50%, the distributions of the Li-rich phase region and the Li-poor phase region appear differently in Figs. 6C and 6D.

Referring to FIG. 6C, at the SOC 50% of the battery 20, the Li-poor phase regions P(1) and P(2) exist at the outer boundary (or the surface) and center of the positive electrode active material particle, respectively, and the Li-rich phase region R(1) exists between two Li-poor phase regions P(1) and P(2). Thereafter, when the discharge of the battery 20 is initiated, the Li-rich phase region R(1) may be created on the outer boundary of the positive electrode active material particle due to the intercalation of lithium ions. When the SOC of the battery 20 reaches 40%, all previous Li-poor phase regions P(1) are transited to the Li-rich phase regions R(1), and accordingly, only one Li-rich phase region R(1) and one Li-poor phase region P(1) may exist at the outer boundary and center of the positive electrode active material particle, respectively.

Referring to FIG. 6D, at 50% SOC of the battery 20, Li-rich phase regions (R(1), R(2)) exist at the outer boundary (or the surface) and center of the positive electrode active material particle, respectively, and the Li-poor phase region P(1) exists between two Li-rich phase regions R(1), R(2). Thereafter, when the discharge of the battery 20 is initiated, the interface of the Li-rich phase region R(1) and the Li-poor phase region P(1) may gradually move toward the center side of the positive electrode active material particle due to the intercalation of lithium ions.

As examined herein, even if the SOC of the battery 20 is the same, the distribution state of lithium ions in the positive electrode active material may vary depending on the path through which the battery 20 was previously charged and discharged, and this characteristic of the battery 20 is referred to as a path dependency. The path dependency of the battery 20 may affect the internal resistance of the battery 20 and the additional overpotential generated thereby.

The control device 13 may estimate the influence information of the path dependency by monitoring the distribution status of lithium ions in the positive electrode of the battery 20. That is, the control device 13 may estimate the degree to which the internal resistance of the battery 20 changes due to path dependence based on the state of lithium ion distribution within the positive electrode active material of the battery 20. The control device 13 may determine the internal resistance detection section in a section that satisfies the condition (a third condition) that the variation level of the estimated internal resistance is below a predetermined level.

The control device 13 can continuously detect and record the distribution state of lithium ions within the positive electrode active material of the battery 20 to monitor the influence of the path dependency on the internal resistance of the battery 20. The control device 13 may estimate the lithium ion distribution state within the positive electrode active material based on the SOC of the battery 20. As shown in FIG. 5A to FIG. 5D, and FIG. 6A to FIG. 6D, the control device 13 may estimate the lithium ion distribution state within the positive electrode active material by modeling how the Li-rich phase region and the Li-poor phase region change within the positive electrode active material particle according to the SOC. The control device 13 may obtain a position information representing the lithium ion distribution state by converting the estimated lithium ion distribution state into a coordinate information. The control device 13 may record the distribution state of lithium ions in the positive electrode active material by storing the position information thus acquired in correspondence with the corresponding SOC in the storage device 11.

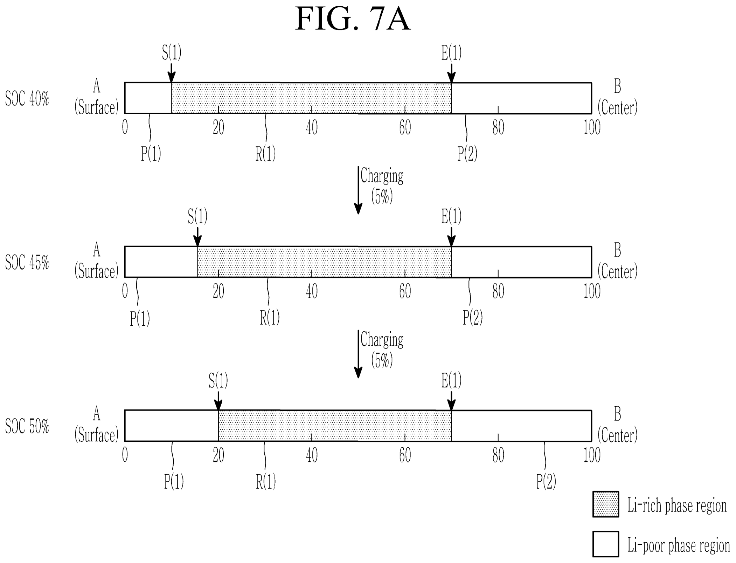

FIG. 7A to FIG. 7D are drawings for explaining how a control device 13 records a distribution state of lithium ions in a positive electrode active material of a battery 20.

FIG. 7A to FIG. 7D illustrate examples of converting the region between the center and the outer boundary of the positive electrode active material particle into a one-dimensional coordinate system of a form of a bar graph, and use this one-dimensional coordinate system to record the position information (a start position $S(i)$ and an end position $E(i)$) of each Li-rich phase region $R(i)$. $S(i)$ and $E(i)$ are the position information of the Li-rich phase region $R(i)$ located at the i-th position from the outer boundary (or the surface) of the positive electrode active material particle, and $S(i)$ and $E(i)$ indicate the start and the end positions of the Li-rich phase region $R(i)$, respectively. In this specification, the i-th Li-rich phase region $R(i)$ means the Li-rich phase region located i-th closest from the outer boundary (or the surface) of a positive electrode active material particle, and the i-th Li-poor phase region $P(i)$ means the Li-poor phase region located i-th closest from the outer boundary (or the surface) of the positive electrode active material particle.

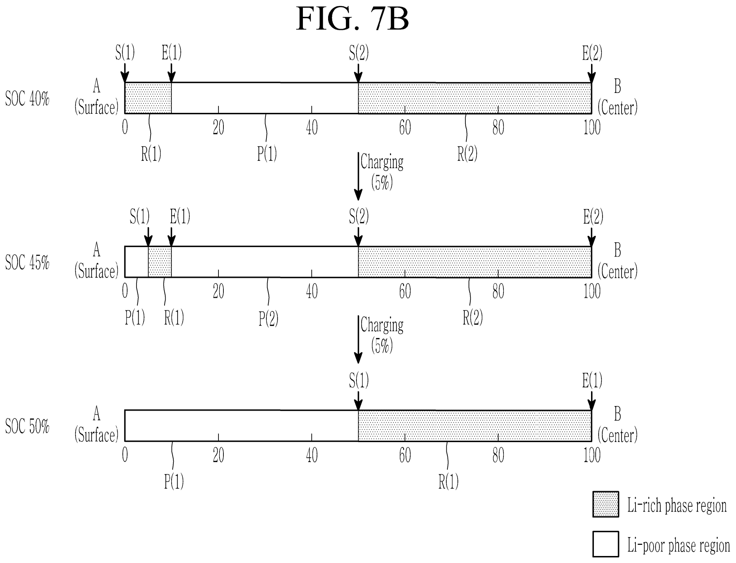

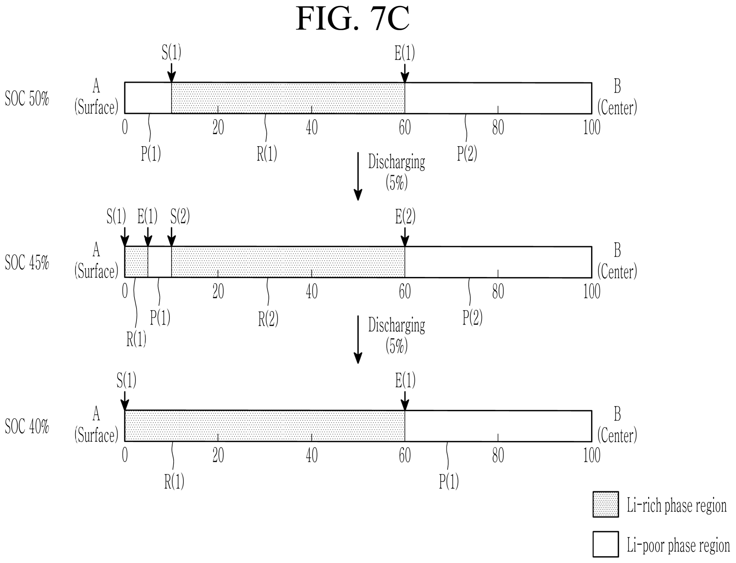

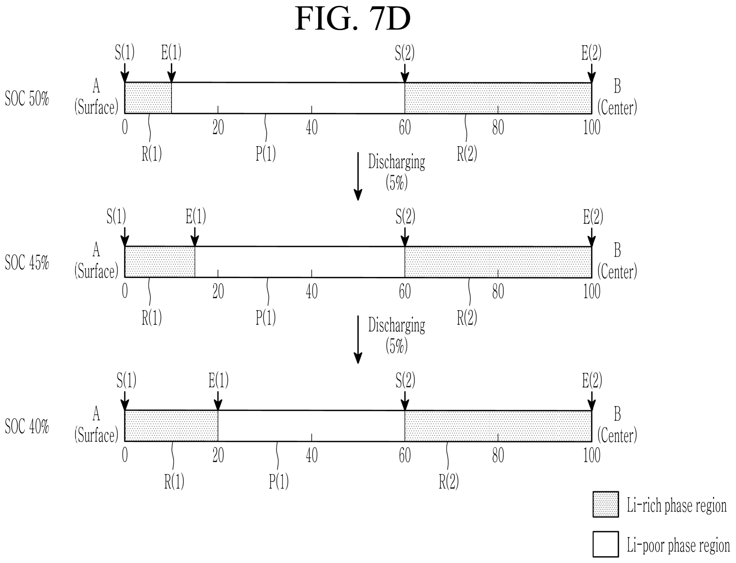

Referring to FIG. 7A as an example, the position information of the first Li-rich phase region $R(1)$ may be determined as $(S(1), E(1)) = (10, 70)$ when the SOC is 40%, $(S(1), E(1)) = (15, 70)$ when the SOC is 45%, and $(S(1), E(1)) = (20, 70)$ when the SOC is 50%. Referring to FIG. 7B as an example, the position information of the first Li-rich phase region $R(1)$ may be determined as $(S(1), E(1)) = (0, 10)$ when the SOC is 40%, $(S(1), E(1)) = (5, 10)$ when the SOC is 45%, and $(S(1), E(1)) = (50, 100)$ when the SOC is 50%, and the position information of the second Li-rich phase region $R(2)$ may be determined as $(S(2), E(2)) = (50, 100)$ when the SOC is 40% and $(S(2), E(2)) = (50, 100)$ when the SOC is 45%. Referring to FIG. 7C as an example, the position information of the first Li-rich phase region $R(1)$ may be determined as $(S(1), E(1)) = (10, 60)$ when the SOC is 50%, $(S(1), E(1)) = (0, 5)$ when the SOC is 45%, and $(S(1), E(1)) = (0, 60)$ when the SOC is 40%, and the position information of the second Li-rich phase region $R(2)$ may be determined as $(S(2), E(2)) = (10, 60)$ when the SOC is 45%. Referring to FIG. 7D as an example, the position information of the first Li-rich phase region $R(1)$ may be determined as $(S(1), E(1)) = (0, 10)$ when the SOC is 50%, $(S(1), E(1)) = (0, 15)$ when the SOC is 45%, and $(S(1), E(1)) = (0, 20)$ when the SOC is 40%, and the position information of the second Li-rich phase region $R(2)$ may be determined as $(S(2), E(2)) = (60, 100)$ when the SOC is 50%, $(S(2), E(2)) = (60, 100)$ when the SOC is 45%, and $(S(2), E(2)) = (60, 100)$ when the SOC is 40%.

When the position information (the start position $S(i)$ and the end position $E(i)$) of each Li-rich phase region $R(i)$ is determined, the control device 13 may record this together with the corresponding SOC in the storage device 11. Accordingly, the history of the change in the SOC of the battery 20 and the corresponding history of the change in the Li-rich phase region $R(i)$ may be recorded in the storage device 11.

In FIG. 7A to FIG. 7D, the distribution state of lithium ions in the positive electrode active material particle was recorded by recording the location information (the start position S(i), the end position E(i)) of the Li-rich phase region R(i). However, in embodiments, the distribution state of lithium ions within the positive electrode active material particle may also be recorded by recording the position information (the start position, the end position) of the Li-poor phase region P(i). When the Li-rich phase region and the Li-poor phase region coexist within the positive electrode active material particle, the control device 13 may estimate the position information of the remaining phase regions based on the determined position information of one phase region.

The positive electrode of the battery 20 may include a plurality of positive electrode active material particle, and even at the same time, the lithium ion distribution state may be different for each positive electrode active material particle. The control device 13 may estimate the distribution state of lithium ions for one positive electrode active material particle in the manner described herein. Then, the control device 13 may assume that the estimated lithium ion distribution state for one positive electrode active material particle is the average lithium ion distribution state of all positive electrode active material particles included in the positive electrode of the battery 20.

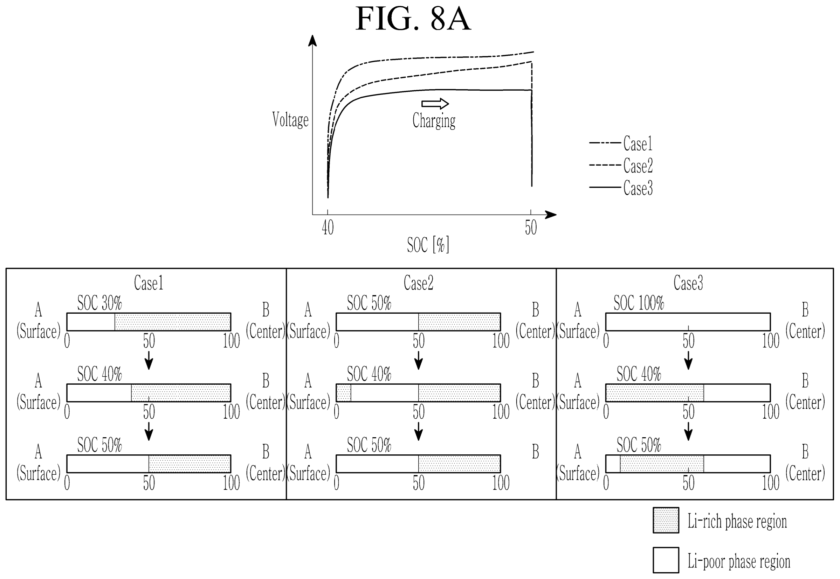

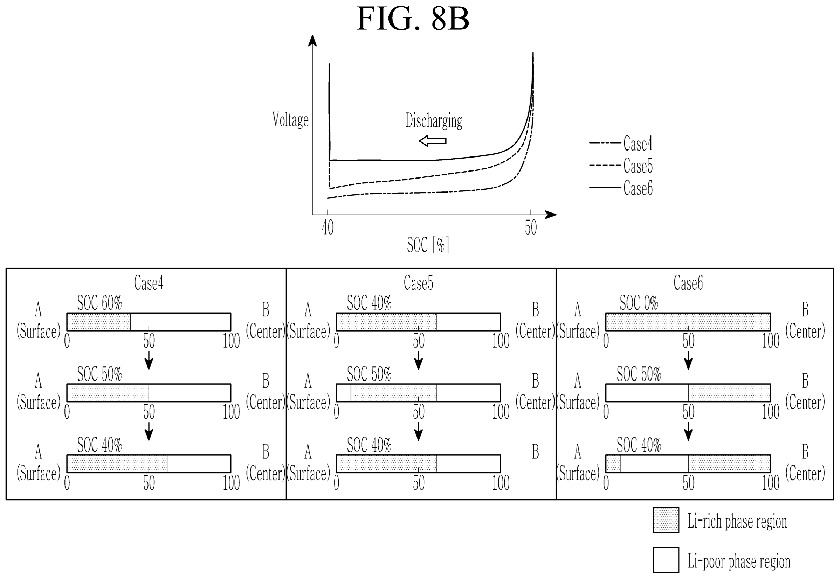

FIG. 8A and FIG. 8B are drawings for explaining a change in an internal resistance depending on a charge/-discharge path of a battery 20.

In FIG. 8A, a Case 1, a Case 2, and a Case 3 all illustrate voltage variation that additionally occur due to variation in the internal resistance value of the battery 20 when charging the battery 20 from a SOC 40% to a SOC 50%.

Case 1 illustrates a case where the SOC of the battery 20 is charged from 30% to 40% and then charged again to the SOC 50%. In this case, when the SOC of the battery 20 is 40%, the Li-poor phase region may exist on the outer boundary (surface) of the positive electrode active material particle of the battery 20. Therefore, while the battery 20 is charged from the SOC 40% to the SOC 50%, lithium ions escape through the Li-poor phase region toward the negative electrode side. Due to this, the internal resistance value of the battery 20 may increase significantly while the battery 20 is charged from the SOC 40% to the SOC 50%, and thus additional voltage variation due to the internal resistance may be significant.

The Case 2 illustrates a case where the SOC of the battery 20 is discharged from 50% to 40% and then charged again to the SOC 50%. In this case, when the SOC of the battery 20 is 40%, the Li-rich phase region may exist on the outer boundary (surface) of the positive electrode active material particle of the battery 20. Therefore, while the battery 20 is charged from the SOC 40% to the SOC 50%, lithium ions preferentially escape from the Li-rich phase region located at the outer boundary of the positive electrode active material particle. Due to this, the additional voltage variation due to the internal resistance may be reduced while the battery 20 is charged from the SOC 40% to the SOC 50% compared to the Case 1.

A Case 3 illustrates a case where the SOC of the battery 20 is discharged from 100% to 40% and then charged again to the SOC 50%. In this case, when the SOC of the battery 20 is 40%, the Li-rich phase region may exist on the outer boundary (surface) of the positive electrode active material particle of the battery 20. Therefore, while the battery 20 is charged from the SOC 40% to the SOC 50%, lithium ions preferentially escape from the Li-rich phase region located at the outer boundary of the positive electrode active material particle. Due to this, the additional voltage variation due to the internal resistance may be reduced while the battery 20 is charged from the SOC 40% to the SOC 50% compared to the Case 1.

When the Li-rich phase region is located at the outer boundary (the surface) of the positive electrode active material particle at the start of the charging, the increase rate in the internal resistance of the battery 20 during the subsequent charging may vary depending on the thickness of the Li-rich phase region located at the outer boundary of the positive electrode active material particle. The thicker the Li-rich phase region located on the outer boundary of the positive electrode active material particle, the lower the increase rate in the internal resistance of the battery 20 during the charging. On the other hand, the thinner the Li-rich phase region located on the outer boundary of the positive electrode active material particle, the higher the increase rate in the internal resistance of the battery 20 during charging may be.

In the Case 2, the battery 20 is discharged from the SOC 50% to SOC 40% in the previous discharge stage and then the charge is again initiated. In the Case 3, the battery 20 is discharged from the SOC 100% to SOC 40% in the previous discharge stage and then the charge is again initiated. Therefore, comparing the Case 2 and the Case 3, at the time of re-initiating charging, the thickness of the Li-rich phase region located at the outer boundary of the positive electrode active material particle is thicker in the Case 3 than in the Case 2. Accordingly, the internal resistance of the battery 20 increases more slowly in the Case 3 than in the Case 2, and the additional voltage increase rate caused by the internal resistance may also be lower.

In FIG. 8B, a Case4, a Case5, and a Case6 all illustrate the voltage variation that additionally occur due to the variation in the internal resistance value of the battery 20 when discharging the battery 20 from the SOC 50% to the SOC 40%.

A Case 4 illustrates a case where the SOC of the battery 20 is discharged from 60% to 50% and then discharged again to the SOC 40%. In this case, when the SOC of the battery 20 is 50%, a Li-rich phase region may exist on the outer boundary (surface) of the positive electrode active material particle of the battery 20. Therefore, while the battery 20 is discharged from SOC 50% to SOC 40%, lithium ions are intercalated through the Li-rich phase region. Due to this, the internal resistance value of the battery 20 increases while the battery 20 is discharged from the SOC 50% to the SOC 40%, and the additional voltage variation due to the internal resistance may occur significantly.

A Case 5 illustrates a case where the SOC of the battery 20 is charged from 40% to 50% and then discharged back to the SOC 40%. In this case, when the SOC of the battery 20 is 50%, the Li-poor phase region may exist on the outer boundary (surface) of the positive electrode active material particle of the battery 20. Therefore, while the battery 20 is discharged from SOC 50% to SOC 40%, lithium ions are preferentially intercalated into the Li-poor phase region located at the outer boundary of the positive electrode active material particle. This may reduce the additional voltage variation that occur due to the increase in the internal resistance while the battery 20 is discharged from the SOC 50% to the SOC 40% compared to the Case 4.

A Case 6 illustrates a case where the SOC of the battery 20 is charged from 0% to 50% and then discharged again to the SOC 40%. In this case, when the SOC of the battery 20 is 50%, the Li-poor phase region may exist on the outer boundary (surface) of the positive electrode active material particle of the battery 20. Therefore, while the battery 20 is discharged from the SOC 50% to the SOC 40%, lithium ions are preferentially intercalated into the Li-poor phase region located at the outer boundary of the positive electrode active material particle. This may reduce the additional voltage variation that occur due to the increase in the internal resistance while the battery 20 is discharged from the SOC 50% to the SOC 40% compared to Case 4.

When the Li-poor phase region is located at the outer boundary (the surface) of the positive electrode active material particle at the start of the discharge, the rate of the increase in the internal resistance of the battery 20 during the discharge may vary depending on the thickness of the Li-poor phase region located at the outer boundary of the positive electrode active material particle. That is, the thicker the Li-poor phase region located on the outer boundary of the positive electrode active material particle is, the lower the increase rate in the internal resistance of the battery 20 during the discharge may be. On the other hand, the thinner the Li-poor phase region located on the outer boundary of the positive electrode active material particle, the higher the increase rate in the internal resistance of the battery 20 during the discharge may be.

In the Case 5, the battery 20 is charged from the SOC 40% to SOC 50% in the previous charging stage and then discharge is initiated again. In the Case 6, the battery 20 is charged from the SOC 0% to SOC 50% in the previous charging stage and then the discharge is initiated again. Therefore, when comparing the Case 5 and the Case 6, at the time of re-initiating discharge, the thickness of the Li-poor phase region located at the outer boundary of the positive electrode active material particle is thicker in the Case 6 than in the Case 5. Accordingly, the internal resistance of the battery (20) increases more slowly in the Case 6 than in the Case 5, and the additional voltage drop caused by the internal resistance may also be less.

As examined herein, the Li-rich phase region exists on the outer boundary (surface) of the positive electrode active material particle during the charging, and as the thickness of the corresponding Li-rich phase region increases, the variation range of the internal resistance value and the resulting overpotential generation range may be reduced. In addition, during the discharge, the Li-poor phase region exists on the outer boundary (surface)of the positive electrode active material particle, and as the thickness of the corresponding Li-poor phase region increases, the variation range of the internal resistance value and the resulting overpotential generation range may be reduced.

The control device 13 may estimate the degree to which the internal resistance varies due to the influence of the path dependence by analyzing the distribution state of lithium ions in the positive electrode active material. The control device 13 may calculate an internal resistance variation index K_rate based on the distribution state of lithium ions in the positive electrode active material to estimate the degree to which the internal resistance varies due to the influence of the path dependency.

During charging, the control device (13) can calculate the internal resistance variation index K_rate based on the position and thickness of the Li-rich phase region as shown in the following mathematical formula 2.

[Mathematical formula 2]

If (S_R_init (R(1)) < S_P_init (P(1))) || (S_R (R (1)) < S_P_init (P(1)))

K_rate = S_R (R (1))/ S_P_init (P(1))

Else

K_rate = 1

In the above Mathematical formula 2, S_R_init (R(1)) and S_P_init (P(1)) record the starting positions of the first Li-rich phase region R(1) and the first Li-poor phase region P(1), respectively, at the start of the charging. S_R(R(1)) records the starting position of the first Li-rich phase region R(1) while the charging is in progress.

Referring to the above Mathematical formula 2, the control device 13 may check whether the condition S_R_init (R(1)) < S_P_init (P(1)) that the starting position of the first Li-rich phase region R(1) is located further outward than the starting position of the first Li-poor phase region P(1) at the start of the charging, or the condition S_R (R (1)) < S_P_init (P(1)) that the starting position of the first Li-rich phase region R(1) during the charging is located further outward than the starting position of the first Li-poor phase region P(1) recorded at the start of the charging, is satisfied. The satisfaction of the condition S_R_init (R(1)) < S_P_init (P(1)) may mean that the Li-rich phase region R(1) exists on the surface of the positive electrode active material particle at the start of the charging (referring to the SOC 40% state in FIG. 6B). The satisfaction of the condition S_R (R (1)) < S_P_init (P(1)) may mean that at the start of the charging, the Li-rich phase region R(1) is located at the surface of the positive electrode active material particle, and as the charging progresses, the Li-rich phase region R(1) gradually transitions to the Li-poor phase region P(1) by losing lithium ions (referring to the SOC 45% state in FIG. 6B).

If the condition S_R_init (R(1)) < S_P_init (P(1)) or the condition S_R (R(1)) < S_P_init (P(1)) is satisfied, S_P_init (P(1)) may correspond to the end position of the first Li-rich phase region R(1). Accordingly, the control device 13 can derive the internal resistance variation index K_rate from the ratio S_R (R (1))/ S_P_init (P(1)) of the starting position to the ending position of the first Li-rich phase region (R(1)) if the condition S_R_init (R(1)) < S_P_init (P(1)) or the condition S_R (R(1)) < S_P_init (P(1)) is satisfied. The internal resistance variation index K_rate calculated in this way may decrease as the starting position of the first Li-rich phase region R(1) is closer to the outer side of the positive electrode active material particle, and as the ending position of the first Li-rich phase region R(1) is closer to the center side of the positive electrode active material particle (i.e., as the thickness of the first Li-rich phase region R(1) is thicker).

If both the condition S_R_init (R(1)) < S_P_init (P(1)) and the condition S_R (R (1)) < S_P_init (P(1)) are not satisfied, the control device 13 can set the internal resistance variation index K_rate to a fixed value (e.g., 1).

During discharge, the control device (13) can calculate the internal resistance variation index K_rate based on the position and thickness of the Li-poor phase region as shown in the following mathematical formula 3.

[Mathematical Formula 3]

If S_P_init (P(1)) < S_R_init (R(1)) || S_P (P(1)) < S_R_init (R(1))

K_rate = S_P (P(1))/ S_R_init (R(1))

Else

K_rate = 1

In the above Mathematical Formula 3, S_R_init (R(1)) and S_P_init (P(1)) record the starting positions of the first Li-rich phase region R(1) and the first Li-poor phase region P(1), respectively, at the start of discharge. The S_P (P(1)) records the starting position of the first Li-poor phase region (P(1)) while the discharge is in progress.

Referring to the above Mathematical Formula 3, the control device 13 may check whether the condition S_P_init (P(1)) < S_R_init (R(1)) that the starting position of the first Li-poor phase region P(1) at the time of discharge initiation is located further outward than the starting position of the first Li-rich phase region (R(1)) at the time of discharge initiation or the condition S_P(P(1)) < S_R_init (R(1)) that the starting position of the first Li-poor phase region P(1) during discharge is located further outward than the starting position of the first Li-rich phase region R(1) recorded at the time of the discharge initiation is satisfied. The satisfaction of the condition S_P_init (P(1) < S_R_init (R(1)) may mean that the Li-poor phase region P(1) exists on the outer boundary (surface) of the positive electrode active material particle at the start of the discharge (referring to the SOC 50% state in FIG. 6C). Satisfaction of the condition S_P (P(1) < S_R_init (R(1)) may mean that at the start of the discharge, the Li-poor phase region P(1) is located at the boundary (surface) of the positive electrode active material particle, and as the discharge progresses, the Li-poor phase region P(1) gradually transitions to the Li-rich phase region R(1) due to the intercalation of lithium ions (referring to the SOC 45% state in FIG. 6C).

If the condition S_P_init (P(1)) < S_R_init (R(1)) or the condition S_P (P(1)) < S_R_init (R(1)) is satisfied, S_R_init R(1) may correspond to the end position of the first Li-Poor phase region P(1). Accordingly, the control device 13 may derive the internal resistance variation index K_rate from the ratio (S_P (P(1))/S_R_init (R(1))) of the starting position to the ending position of the first Li-poor phase region P(1) if the condition S_P_init (P(1)) < S_R_init (R(1)) or the condition S_P (P(1)) < S_R_init (R(1)) is satisfied. The internal resistance variation index K_rate calculated in this way may decrease as the starting position of the first Li-poor phase region P(1) is closer to the surface of the positive electrode active material particle, and as the ending position of the first Li-poor phase region P(1) is closer to the center side of the positive electrode active material particle (i.e., as the thickness of the first Li-poor phase region P(1) is thicker).

If both the condition S_P_init (P(1)) < S_R_init (R(1)) and the condition S_P (P(1)) < S_R_init (R(1)) are not satisfied, the control device 13 may set the internal resistance variation index K_rate as a fixed value (e.g., 1).

The control device 13 may determine a section in which the internal resistance variation index K_rate is lower than a predetermined value (e.g., 0.3) as a section with a low influence of path dependency on the internal resistance value. Accordingly, the control device 13 may determine a section in which the internal resistance variation index K_rate is lower than a threshold (e.g., 0.3) as the internal resistance detection section.

Due to the memory effect of the LFP, as the idle time (a time when the current is 0) of the battery 20 becomes longer, a voltage overshooting due to the overpotential in the charging or discharging section immediately following the idle time may increase. As the idle time increases, a electrochemical dynamic decreases, requiring more energy for the battery 20 to transition to an active state. This overshooting may cause the additional overpotential, which may reduce the accuracy of the internal resistance detection.

Accordingly, the control device 13 may determine the internal resistance detection section in the corresponding charging section or discharging section when the charging or the discharging is initiated (a fourth condition) while the idle time is less than a predetermined time.

The control device 13 may count the idle time of the battery 20 by using a counter. The control device 13 may continuously increase a counter value that counts the idle time during the idle section of the battery 20. The control device 13 may maintain the counter value without increasing it during the charging or discharging section after the idle section. The control device (13) can reset the previously counted idle time counter value to 0 when the direction of the current changes from charging to discharging or from discharging to charging. The control device 13 may determine the internal resistance detection section in the charging section or the discharging section in which the thus counted idle time counter value remains below a predetermined value.

The control device 13 may determine the internal resistance detection section within a section that simultaneously satisfies all of the herein-mentioned first to fourth conditions. The control device 13 may also determine the internal resistance detection section within a section in which at least some of the first to fourth conditions described herein are simultaneously satisfied.

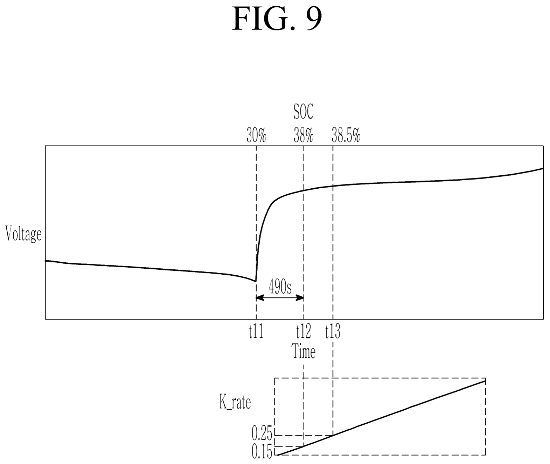

FIG. 9 is a view illustrating an example in which a control device 13 determines an internal resistance detection section. FIG. 9 illustrates an example of the change in the voltage measured from the battery 20 during the period in which the battery 20 is discharged from 40% to 30% and then charged back to 40%. The battery 20 used at this time has a time constant $\tau$ of 90 s for a parallel impedance (a parallel resistance Rp and a parallel capacitance Cp) and an OCV flat section at the SOC 30% to 55% and the SOC 65% to 95%.

Referring to FIG. 9, the charging of the battery 20 begins at a time t11, and a charging maintenance time until a time t12 is 490 s. Since the charging maintenance time up to the time t12 is greater than 5$\tau$ (450 s), the section t12 to t13 may satisfy the first condition described herein. The SOC of the battery 20 detected at the times t12 and t13 are 38% and 38.5%, respectively, which correspond to the OCV flat section of the battery 20. Therefore, the section t12 to t13 may satisfy the second condition described herein. At the times t12 and t13, the internal resistance variation index K_rate is lower than the threshold (0.3) set to 0.15 and 0.25, respectively. Therefore, the section t12 to t13 may satisfy the third condition mentioned herein. At the time t11, the current flow of the battery 20 changes from the discharging to the charging. Therefore, the previously counted idle time is reset to 0, so that the section t12 to t13 may satisfy the fourth condition described herein.

As described herein, since the charging section between t12 and t13 satisfies all the conditions for determining the internal resistance detection section, the control device 13 may determine the corresponding section as the internal resistance detection section. That is, the control device 13 can determine the internal resistance value of the battery 20 using the voltage value and current value of the battery 20 measured within the period t12 to t13. The control device 13 may measure the voltage value and the current value of the battery 20 at two different times within the period t12 to t13, and determine the internal resistance value of the battery 20 by substituting the measured voltage values and current values into the aforementioned Mathematical Formula 1.

When the internal resistance value of the battery 20 is determined, the control device 13 may detect an abnormality in the battery 20, such as an internal short circuit, based on this. In addition, the control device 13 may perform a protection function of the battery 20, such as blocking the charge/discharge current, when the abnormality in the battery 20 is detected.

When the internal resistance value of the battery 20 is determined, the control device 13 may transmit the internal resistance value of the battery 20 to an upper-level controller (e.g., a vehicle controller, etc.).

The control device 13 may include at least one processor for performing the functions of the control device 13 mentioned in this specification. The processor may refer to a data processing device having a physically structured circuit to perform a function expressed in a code or instruction included in a program, such as a microprocessor, a central processing unit (CPU), a processor core, a multiprocessor, an application-specific integrated circuit (ASIC), or a field programmable gate array (FPGA).

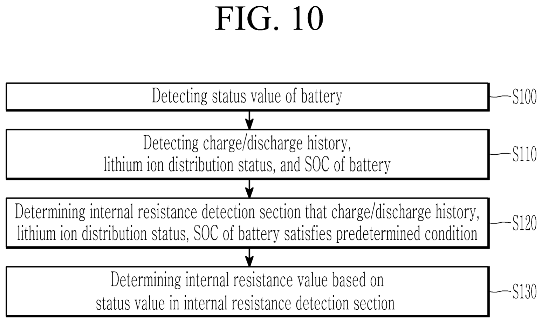

FIG. 10 is a view schematically illustrating a method for detecting an internal resistance of a battery according to embodiments. The method of FIG. 10 may be performed by the control device 13 described with reference to FIG. 1 to FIG. 9 above.

Referring to Fig. 10, the control device 13 may detect the status value of the battery 20 via the measuring device 12 (step S100). That is, the control device 13 may detect the voltage value and the current value of the battery 20 via the measuring device 12. The measuring device 12 periodically measures the status value of the battery 20 using at least one sensor and can transmit the measured status value to the control device 13.

The control device 13 may detect a charge/discharge history, a lithium ion distribution status, and a SOC of the battery 20 (step S110).

At the step S110, the charge/discharge history may include a charge maintenance time, a discharge maintenance time, an idle time, etc. The control device 13 may count the charge maintenance time, the discharge maintenance time, and the idle time using at least one counter.

At the step S110, the control device 13 may determine the SOC of the battery 20 based on the status value detected through the step S100. In addition, by estimating the distribution state of the Li-rich phase region and the Li-poor phase region within the positive electrode active material particle based on the SOC of the battery 20, the distribution state of lithium ions within the positive electrode active material of the battery 20 may be estimated.

The control device 13 may select a section in which the detected charge/discharge history, lithium ion distribution status, and SOC of the battery 20 satisfy predetermined conditions through the step S110, and determine the section as an internal resistance detection section (step S120).

At the step S120, the control device 13 may determine the internal resistance detection section in a section that satisfies the condition that the charge maintenance time or discharge maintenance time of the battery 20 is greater than or equal to the minimum maintenance time. The control device 13 may determine the internal resistance detection section in the charging section after the charging is maintained for the minimum maintenance time or longer when the battery 20 is being charged. The control device 13 may determine the internal resistance detection section in the discharging section after the discharge is maintained for the minimum maintenance time or longer when the battery 20 is discharging.

At the step S120, the control device 13 may determine the internal resistance detection section in a section that satisfies the condition that the SOC of the battery 20 is included within the SOC range corresponding to the OCV flat section.

At the step S120, the control device 13 may estimate the lithium ion distribution state within the positive electrode active material of the battery 20 and calculate an internal resistance variation index based on the estimated lithium ion distribution state. The internal resistance variation index refers to a degree to which the internal resistance varies due to the influence of the path dependency, which is a unique characteristic of the battery 20. The control device 13 may determine the internal resistance detection section in a section where the internal resistance variation index is less than a threshold value.

When the internal resistance detection section is determined, the control device 13 may determine the internal resistance value of the battery 20 using the status values of the battery 20 measured within the internal resistance detection section (step S130). The control device 13 may detect the current value and the voltage value of the battery 20 at different points in time within the internal resistance detection section, and may detect the internal resistance value of the battery 20 using the detected current value and voltage value and the above Mathematical Formula 1.

According to the herein-described embodiments, the internal resistance detection device 10 may calculate the internal resistance value of the battery 20 with a simple calculation using the OCV flat section, which is the unique characteristic of the LFP battery 20. In addition, the internal resistance detection device 10 may improve the accuracy of the internal resistance detection by performing the internal resistance detection in a state where the internal resistance of the battery 20 is stable, that is, in a state where the additional overpotential caused by the path dependency or the idle time is low.

The herein-described embodiments may not be implemented only through the devices and/or methods described herein, but may also be implemented through a program that realizes a function corresponding to the configuration of the embodiments, or a computer-readable recording medium having the program recorded thereon, and such implementation can be easily implemented by a person skilled in the art to which the present disclosure pertains from the description of the herein-described embodiments. The computer-readable recording media include all types of recording devices that store a data that can be read by a computer system. Examples of the computer-readable storage devices include ROM, RAM, CD-ROM, DVD_ROM, DVD_RAM, magnetic tape, floppy disks, hard disks, and optical data storage devices.

While this disclosure has been described in connection with what is presently considered to be practical exemplary embodiments, it is to be understood that the disclosure is not limited to the disclosed embodiments, but, on the contrary, is intended to cover various modifications and equivalent arrangements included within the spirit and scope of the appended claims.

**Claims**

1.  An internal resistance detection device (10) comprising:

    a measuring device (12) configured to measure a state value of a battery (20); and
    a control device (13) configured to determine a state of charge (SOC) of the battery (20) based on the state value, estimate a lithium ion distribution state within a positive electrode active material of the battery (20) based on the SOC, determine a detection section depending on the lithium ion distribution state, and determine an internal resistance value of the battery (20) based on the state value measured within the detection section.

2.  The internal resistance detection device (10) as claimed in claim 1, wherein:

    the positive electrode active material includes LFP($LiFePO_4$); and
    the lithium ion (Li) distribution state includes a distribution state of an Li-rich phase region (R(i)) including an $Li_xFePO_4$ ($x \geq 0.9$) phase and an Li-poor phase region (P(i)) including an $Li_yFePO_4$ ($y \leq 0.05$) phase within a positive electrode active material particle.

3.  The internal resistance detection device (10) as claimed in claim 1 or 2, wherein the control device (13) is further configured to:

    calculate an internal resistance variation index based on the lithium ion distribution state; and
    determine a section in which the internal resistance variation index satisfies a predetermined condition as the detection section.

4.  The internal resistance detection device (10) as claimed in claim 3, wherein:
    the control device (13) is configured to:

    convert a region between an outer boundary and the center of the positive electrode active material particle into a one-dimensional coordinate system;
    estimate a starting position within the positive electrode active material particle of the Li-rich phase region (R(i)) and the Li-poor phase region (P(i)) by using the one-dimensional coordinate system; and
    calculate the internal resistance variation index based on the starting position;
    the starting position of the Li-rich phase region (R(i)) corresponds to the relative distance between the outer boundary and the Li-rich phase region (R(i)); and
    the starting position of the Li-poor phase region (P(i)) corresponds to the relative distance between the outer boundary and the Li-poor phase region (P(i)).

5.  The internal resistance detection device (10) as claimed in claim 3 or 4, wherein:

    the internal resistance variation index during charging decreases as the thickness of the Li-rich phase region (R(i)) located closest to the outer side of the positive electrode active material particles increases if charging is initiated in a state where the Li-rich phase region (R(i)) exists on the outer boundary of the positive electrode active material particle;
    the internal resistance variation index during discharging decreases as the thickness of the Li-poor phase region (P(i)) located closest to the outer side of the positive electrode active material particle increases if the discharge is initiated in a state where the Li-poor phase region (P(i)) exists on the outer boundary of the positive electrode active material particle; and
    the control device (13) is further configured to determine that the predetermined condition is satisfied if the internal resistance variation index is less than a threshold value.

6.  The internal resistance detection device (10) as claimed in any of the preceding claims, wherein:

    an open circuit voltage of the battery (20) is maintained flat within a predetermined SOC range; and
    the control device (13) is further configured to determine the detection section in a section where the SOC of the battery (20) is included within the SOC range.

7.  The internal resistance detection device (10) as claimed in any of the preceding claims, wherein the control device (13) is further configured to determine the detection section in a charging section after a charging is maintained for more than a first time, or in a discharging section after a discharging is maintained for more than the first time, optionally wherein the first time is set based on a time constant of a parallel impedance constituting an equivalent circuit model of the battery (20).

8. The internal resistance detection device (10) as claimed in any of the preceding claims, wherein the control device (13) is further configured to determine the detection section in a corresponding charging section or discharging section if charging or discharging is initiated while an idle time is less than a second time,
optionally wherein the control device (13) is further configured to:

detect, via the measuring device (12), a first voltage value and a first current value of the battery (20) at a first point in a time within the detection section;
detect, via the measuring device (12), a second voltage value and a second current value of the battery (20) at a second point in a time within the detection section; and
calculate the internal resistance value by using a voltage difference between the first voltage value and the second voltage value and a current difference between the first current value and the second current value.

9. An internal resistance detection method of a battery (20), comprising:

measuring a status value of a battery (20);
determining an SOC of the battery (20) based on the status value;
estimating a lithium ion distribution state in a positive electrode active material of the battery (20) based on the SOC of the battery (20);
determining a detection section depending on the lithium ion distribution state; and
determining an internal resistance value of the battery (20) based on the state value measured within the detection section.

10. The internal resistance detection method as claimed in claim 9, wherein:

the positive electrode active material includes LFP ($LiFePO_4$); and
the lithium ion distribution state includes a distribution state of an Li-rich phase region (R(i)) including an $Li_xFePO_4$ ($x \geq 0.9$) phase and an Li-poor phase region (P(i)) including an $Li_yFePO_4$ (y = 0.05) phase within a positive electrode active material particle,
optionally wherein the determining the detection section includes:

calculating an internal resistance variation index based on the lithium ion distribution state; and
determining a section in which the internal resistance variation index satisfies a predetermined condition as the detection section.

11. The internal resistance detection method as claimed in claim 10, wherein:
the estimating the lithium ion distribution state includes:

converting a region between an outer boundary and the center of the positive electrode active material particle into a one-dimensional coordinate system; and
estimating a starting position within the positive electrode active material particle of the Li-rich phase region (R(i)) and the Li-poor phase region (P(i)) by using the one-dimensional coordinate system;
the calculating the internal resistance variation index includes calculating the internal resistance variation index based on the starting position;
the starting position of the Li-rich phase region (R(i)) corresponds to the relative distance between the outer boundary and the Li-rich phase region (R(i)); and
the starting position of the Li-poor phase region (P(i)) corresponds to the relative distance between the outer boundary and the Li-poor phase region (P(i)).

12. The internal resistance detection method as claimed in claim 10 or 11, wherein:

the internal resistance variation index during charging decreases as the thickness of the Li-rich phase region (R(i)) located closest to the outer side of the positive electrode active material particles increases if charging is initiated in a state where the Li-rich phase region (R(i)) exists on the outer boundary of the positive electrode active material particle;

the internal resistance variation index during discharging decreases as the thickness of the Li-poor phase region (P(i)) located closest to the outer side of the positive electrode active material particle increases if the discharge is initiated in a state where the Li-poor phase region (P(i)) exists on the outer boundary of the positive electrode active material particle; and

the determining the section in which the internal resistance variation index satisfies the condition as the detection section includes determining that the condition is satisfied if the internal resistance variation index is less than a threshold value.

13. The internal resistance detection method as claimed in any of the claims 9 to 12, wherein:

an open circuit voltage of the battery (20) is maintained flat within a predetermined SOC range; and
the determining the detection section includes determining the detection section in a section where the SOC of the battery (20) is included within the SOC range.

14. The internal resistance detection method as claimed in any of the claims 9 to 13, wherein the determining the detection section includes determining the detection section in a charging section after a charging is maintained for more than a first time, or in a discharging section after a discharging is maintained for more than the first time, optionally wherein the first time is set based on a time constant of a parallel impedance constituting an equivalent circuit model of the battery (20).

15. The internal resistance detection method as claimed in any of the claims 9 to 14, wherein the determining the detection section includes determining the detection section in the corresponding charging section or discharging section if the charging or discharging is initiated in a state that an idle time is less than a second time,
optionally wherein the determining the internal resistance value includes:

obtaining a first voltage value and a first current value of the battery (20) measured at a first point in time within the detection section;
obtaining a second voltage value and a second current value of the battery (20) measured at a second point in time within the detection section; and
calculating the internal resistance value by using a voltage difference between the first voltage value and the second voltage value and a current difference between the first current value and the second current value.

# FIG. 1

# FIG. 2

FIG. 3

# FIG. 4A

# FIG. 5A

Li-rich phase region

Li-poor phase region

FIG. 5B

FIG. 5C

# FIG. 5D

Discharging →

Li⁺

Li-rich phase region

Li-poor phase region

A (Surface)   0   20   40   60   80   100   B (Center)

A (Surface)   0   20   40   60   80   100   B (Center)

EP 4 773 336 A1

# FIG. 6A

SOC 40%

A (Surface) — B (Center)

P(1) R(1) P(2)

0 20 40 60 80 100

Charging (5%) →

SOC 45%

A (Surface) — B (Center)

P(1) R(1) P(2)

0 20 40 60 80 100

Charging (5%) →

SOC 50%

A (Surface) — B (Center)

P(1) R(1) P(2)

0 20 40 60 80 100

Li-rich phase region

Li-poor phase region

# FIG. 6B

SOC 40%  A (Surface) ... B (Center)
0 — R(1) — 20 — P(1) — 40 — 50 — 60 — R(2) — 80 — 100

Charging (5%)

SOC 45%  A (Surface) ... B (Center)
0 — P(1) — R(1) — 20 — P(2) — 40 — 50 — 60 — R(2) — 80 — 100

Charging (5%)

SOC 50%  A (Surface) ... B (Center)
0 — P(1) — 20 — 40 — 50 — R(1) — 60 — 80 — 100

Li-rich phase region

Li-poor phase region

EP 4 773 336 A1

FIG. 6C

SOC 50%

A (Surface) — 0 — 20 — 40 — 60 — 80 — 100 — B (Center)

P(1)   R(1)   P(2)

Discharging (5%) →

SOC 45%

A (Surface) — 0 — 20 — 40 — 60 — 80 — 100 — B (Center)

R(1)   P(1)   R(2)   P(2)

Discharging (5%) →

SOC 40%

A (Surface) — 0 — 20 — 40 — 60 — 80 — 100 — B (Center)

R(1)   P(1)

Li-rich phase region

Li-poor phase region

# FIG. 6D

SOC 50%  A (Surface) ... B (Center)
0  R(1)  20  P(1)  40  60  R(2)  80  100

Discharging (5%)

SOC 45%  A (Surface) ... B (Center)
0  R(1)  20  P(1)  40  60  R(2)  80  100

Discharging (5%)

SOC 40%  A (Surface) ... B (Center)
0  R(1)  20  P(1)  40  60  R(2)  80  100

Li-rich phase region

Li-poor phase region

EP 4 773 336 A1

# FIG. 7A

EP 4 773 336 A1

FIG. 7B

# FIG. 7C

# FIG. 7D

EP 4 773 336 A1

# FIG. 8A

# FIG. 8B

# FIG. 9

# FIG. 10

| | |
|---|---|
| Detecting status value of battery | —S100 |
| Detecting charge/discharge history, lithium ion distribution status, and SOC of battery | —S110 |
| Determining internal resistance detection section that charge/discharge history, lithium ion distribution status, SOC of battery satisfies predetermined condition | —S120 |
| Determining internal resistance value based on status value in internal resistance detection section | —S130 |

Europäisches
Patentamt

European
Patent Office

Office européen
des brevets

**EUROPEAN SEARCH REPORT**

Application Number

EP 25 22 1340

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2016/052419 A1 (TAKAHASHI KENJI [JP] ET AL) 25 February 2016 (2016-02-25) | 1,4-6,8, 9,11,13, 15 | INV. H01M10/48 H01M4/58 |
| Y | * paragraph [0005] - paragraph [0021] * <br> * paragraph [0064] - paragraph [0067] * <br> * paragraph [0078] - paragraph [0081] * <br> * paragraph [0090] - paragraph [0091] * <br> * paragraph [0129] - paragraph [0134] * <br> * paragraph [0198] - paragraph [0206] * <br> * figures 4-8 * <br> ----- | 2,3,7, 10,14 | G01R31/378 G01R31/3842 G01R31/389 |
| Y | ROSCHER, M.A. ET AL: "Characterisation of charge and discharge behaviour of lithium ion batteries with olivine based cathode active material", <br> JOURNAL OF POWER SOURCES ELSEVIER, AMSTERDAM, NL, <br> vol. 191, no. 2, 15 June 2009 (2009-06-15) , pages 582-590, XP026100435, <br> ISSN: 0378-7753, DOI: 10.1016/J.JPOWSOUR.2009.02.024 [retrieved on 2009-02-20] | 2,3,7, 10,14 | |
| A | * page 583, column 2, paragraph 1 * <br> * page 588, column 2, paragraph 2 * <br> * figure 11 * <br> ----- | 1,4-6,8, 9,11-13, 15 | TECHNICAL FIELDS SEARCHED (IPC) <br> H01M <br> G01R |
| A | MATSUI, H. ET AL: "Open-circuit voltage study on LiFePO"4 olivine cathode", <br> JOURNAL OF POWER SOURCES ELSEVIER, AMSTERDAM, NL, <br> vol. 195, no. 19, <br> 29 April 2010 (2010-04-29), pages 6879-6883, XP027074575, <br> ISSN: 0378-7753, DOI: 10.1016/J.JPOWSOUR.2010.04.072 [retrieved on 2010-06-03] <br> * the whole document * <br> ----- <br> -/-- | 1-8 | |

The present search report has been drawn up for all claims

| Place of search | Date of completion of the search | Examiner |
|---|---|---|
| The Hague | 27 May 2026 | Iglesias van M., H |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 1 of 2

Europäisches Patentamt
European Patent Office
Office européen des brevets

## EUROPEAN SEARCH REPORT

**Application Number**

EP 25 22 1340

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | JP 2013 072659 A (TOYOTA MOTOR CORP) 22 April 2013 (2013-04-22) * the whole document * ----- | 1-15 | |
| A | ZELIC KLEMEN ET AL: "Phase separating electrode materials - chemical inductors?", ENERGY STORAGE MATERIALS, vol. 56, 16 January 2023 (2023-01-16), pages 489-494, XP093400150, ISSN: 2405-8297, DOI: 10.1016/j.ensm.2023.01.008 * the whole document * ----- | 1-8 | |

TECHNICAL FIELDS SEARCHED (IPC)

The present search report has been drawn up for all claims

| Place of search | Date of completion of the search | Examiner |
|---|---|---|
| The Hague | 27 May 2026 | Iglesias van M., H |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

....................................................................

& : member of the same patent family, corresponding document

EPO FORM 1503 03.82 (P04C01)

page 2 of 2

## ANNEX TO THE EUROPEAN SEARCH REPORT
## ON EUROPEAN PATENT APPLICATION NO.

EP 25 22 1340

This annex lists the patent family members relating to the patent documents cited in the above-mentioned European search report.
The members are as contained in the European Patent Office EDP file on
The European Patent Office is in no way liable for these particulars which are merely given for the purpose of information.

27-05-2026

| Patent document cited in search report | | Publication date | Patent family member(s) | | Publication date |
|---|---|---|---|---|---|
| US 2016052419 | A1 | 25-02-2016 | CN 105190985 A | | 23-12-2015 |
| | | | DE 112013006931 T5 | | 07-01-2016 |
| | | | JP 5862836 B2 | | 16-02-2016 |
| | | | JP WO2014167602 A1 | | 16-02-2017 |
| | | | US 2016052419 A1 | | 25-02-2016 |
| | | | WO 2014167602 A1 | | 16-10-2014 |
| JP 2013072659 | A | 22-04-2013 | JP 5737106 B2 | | 17-06-2015 |
| | | | JP 2013072659 A | | 22-04-2013 |

EPO FORM P0459

For more details about this annex : see Official Journal of the European Patent Office, No. 12/82